# EUROPEAN PATENT SPECIFICATION

(11) **EP 2 774 891 B1**
(45) Date of publication and mention of the grant of the patent: **23.10.2019**
(21) Application number: 13157834.6
(22) Date of filing: 05.03.2013
(51) Int. Cl.: B81C 1/00, G01L 9/00, H01L 23/48

(54) **Semiconductor device with capacitive sensor and integrated circuit**
Halbleitervorrichtung mit kapazitivem Sensor und integrierter Schaltung
Dispositif semi-conducteur doté d'un capteur capacitif et d'un circuit intégré

(43) Date of publication of application: 10.09.2014
(60) Divisional application: 19197385.8
(73) Proprietor: ams AG, 8141 Premstätten (AT)
(72) Inventor: Forsyth, Richard, 8141 Premstätten (AT)
(74) Representative: Epping - Hermann - Fischer

(56) References cited:
- EP-A2- 2 060 533
- WO-A1-2009/133961
- US-A1- 2011 291 167

## Description

Capacitive sensors comprise an arrangement of electrodes and capacitor dielectric with a variable capacitance correlated to a physical quantity that is to be measured. An acceleration or a direction relative to a gravitational field, for example, can be detected by measuring the capacitance of an array of electrodes of variable relative positions. Fixed electrodes can be used to detect an agent that affects the capacitor dielectric and thus changes the capacitance, like humidity or the presence of a special gas, for instance.

US 6,472,243 B2 discloses a method of forming an integrated CMOS capacitive pressure sensor, which utilizes a diaphragm that is formed along with gate electrodes of active devices on the same semiconductor substrate.

US 7,705,613 B2 discloses a capacitive fingerprint sensor with an array of sensor electrodes on a sensor chip, covered with an insulating layer. A fingertip touching the insulating layer acts as a further capacitor plate. Conductive vias through the sensor chip connect the sensor electrodes with terminals of a further chip including active detection circuitry. The connection between the chips can be effected by means of an interposer. The sensor chip and the active detection circuitry chip may be one and the same. Moreover, where an interposer is used, the interposer can optionally also act as the "package" for the assembly if the sensor chip and active detection circuitry chip are one and the same.

EP 2060533 A2 discloses a semiconductor device comprising a substrate, an integrated circuit, wiring layers and through-electrodes connecting one of the wiring layers with an intermediate silicon layer and with a substrate layer including a MEMS structure. Capacitor elements formed in the MEMS structure are connected with the integrated circuit via the through-electrodes.

WO 2009/133961 A1 discloses methods of manufacturing capacitive electromechanical transducers comprising an upper electrode and a lower electrode. A DC bias voltage is applied between the electrodes during operation of the transducer. An embodiment comprises a through-substrate via with a conductive portion connected to the lower electrode.

US 2011/0291167 A1 discloses a semiconductor device comprising a MEMS capacitor arranged above an insulating layer covering a wiring. An embodiment comprises a through hole in the semiconductor substrate. The through hole reduces the parasitic capacitance between the MEMS sensor and the substrate. An insulator layer fills the through hole to enhance the mechanical stability of the substrate.

WO 2010/006916 A1 discloses a semiconductor device with a through-silicon via. A connection pad is arranged in the insulation layer of an SOI substrate, and a contact hole is formed in the silicon above the pad. A metallization is applied to the pad and to the sidewall of the hole and connects the pad with a top metal.

It is an object of the invention to provide a monolithically integrated capacitive sensor for easy mounting and narrow production tolerances.

This object is achieved with the semiconductor device according to claim 1. Embodiments derive from the dependent claims.

The semiconductor device comprises a substrate of semiconductor material with a main surface and an opposite back surface, at least one integrated component in the substrate at or near the main surface, a plurality of electric conductors at or above the main surface, the integrated component being electrically connected with the electric conductors, a capacitor electrode and at least one further capacitor electrode arranged at or above the back surface, and through-substrate vias with metallizations. Each of the metallizations connects one of the electric conductors with either the capacitor electrode or the further capacitor electrode. At least one electrically floating coupling electrode is arranged in the vicinity of the capacitor electrode and the further capacitor electrode.

The term through-substrate via is used to designate an electric interconnect through the substrate, which is known per se in semiconductor technology also as a through-silicon via or a through-wafer via.

According to the invention the capacitor electrode and the further capacitor electrode are arranged at the same level at a distance from the back surface.

In an embodiment of the invention the capacitor electrode and the further capacitor electrode are interdigitated.

In a further embodiment the coupling electrode is arranged at a distance from the back surface, and the capacitor electrode and the further capacitor electrode are arranged within this distance from the back surface.

In a further embodiment the coupling electrode is fixed relative to the capacitor electrode and the further capacitor electrode.

In a further embodiment a dielectric material is arranged between the capacitor electrode, the further capacitor electrode and/or the coupling electrode. The dielectric material may be provided for a gas sensor or for a humidity sensor.

In a further embodiment the coupling electrode is movable with respect to the capacitor electrode and the further capacitor electrode.

In a further embodiment a dielectric material forms a recess or void at or above the back surface, and the coupling electrode is suspended within the recess or void by means of suspensions extending to or into the dielectric material.

In a further embodiment solder balls are arranged on some of the electric conductors, thus enabling an external electric connection of the electric conductors. The solder balls are suitable for mounting the semiconductor device on a carrier like a printed circuit board. The solder balls are connected to electric conductors of the carrier.

A further embodiment comprises a plurality of further capacitor electrodes arranged at or above the back surface, a plurality of further coupling electrodes and a plurality of through-substrate vias with metallizations. Each of the further coupling electrodes is arranged in the vicinity of one or more of the further capacitor electrodes, and the metallizations provide connections between the electric conductors and the further capacitor electrodes in pairs that are each formed by one of the electric conductors and one of the further capacitor electrodes.

Further embodiments especially relate to capacitive sensors which have three electrodes. A first electrode and a second electrode are connected to a sensing circuitry by means of through-substrate vias. A third electrode, which need not be electrically connected, serves to provide a capacitive coupling between the first and second electrodes. Depending on the application, the first and second electrodes may be interdigitated to yield a high capacitance and present a large coupling area overlapped by the third electrode. The third electrode may in particular be movable, and the first and second electrodes may be patterned to be sensitive to the position of the third electrode in one, two or three orthogonal spatial directions X, Y, Z, for example.

The following is a detailed description of examples of the semiconductor device in conjunction with the accompanying drawings.
- Figure 1: shows a cross section of an embodiment comprising a fixed coupling electrode.
- Figure 2: shows a cross section of an embodiment comprising a movable coupling electrode.
- Figure 3: shows a cross section of an embodiment comprising several fixed coupling electrodes.
- Figure 4: shows a cross section of an embodiment comprising several movable coupling electrodes.
- Figure 5: shows a plan view of the embodiments of Figures 1 and 2.
- Figure 6: shows a plan view of a further embodiment.

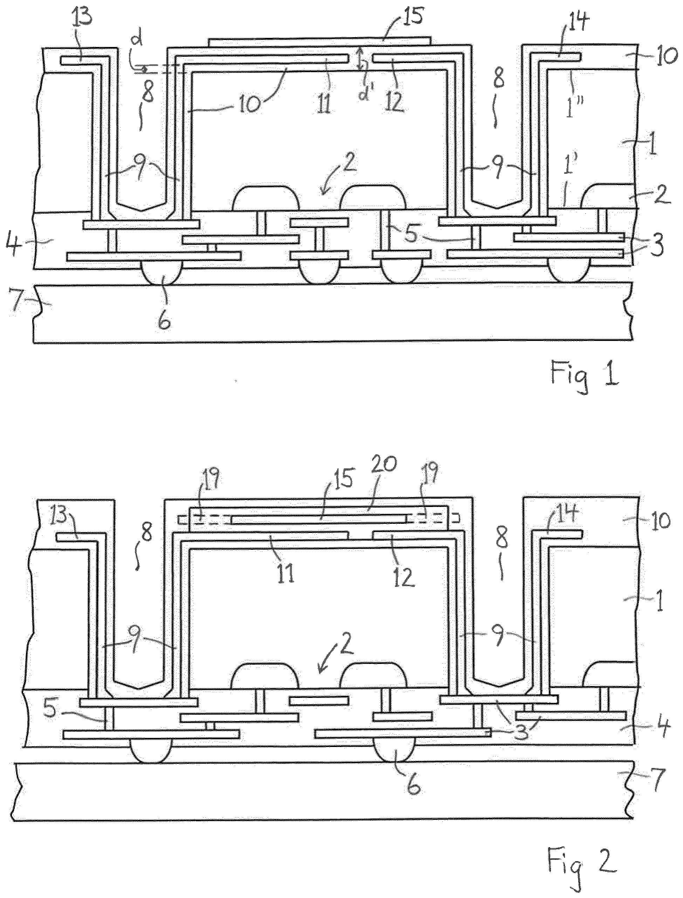

Figure 1 shows a cross section of an embodiment of the semiconductor device comprising a substrate 1 of semiconductor material, which may be silicon, for instance. Integrated components 2, which are indicated in Figure 1 as transistor structures, are arranged in the substrate 1 at or near a main surface 1'. The integrated components 2 may be any components of an integrated circuit, particularly CMOS components, for instance, and may especially be provided as part of a read-out or control circuit used to read a sensor signal or to perform computations. Electric conductors 3 are arranged at or above the main surface 1' and may be formed by structured metal layers, especially metallization layers of a wiring, which may be embedded in an intermetal dielectric 4. Plugs 5 may be provided as vertical electric connections between the electric conductors 3. The arrangement of electric conductors 3 and plugs 5 is shown in Figure 1 for illustration only and may be varied according to the individual requirements of the different embodiments of the semiconductor device.

The electric conductors 3 can be provided with solder balls 6 in order to enable an external electric connection. The solder balls 6 are preferably arranged on electric conductors 3 that belong to the uppermost metal layer. If the semiconductor device is to be mounted upside down on a carrier 7, like a printed circuit board, for instance, as shown in Figure 1, the solder balls 6 allow the electric conductors 3 to be electrically connected with further electric conductors of the carrier 7. Solder balls 6 and a carrier 7 are optional, and the carrier 7 may be provided with any suitable structure of electric conductors, depending on the type and intended purpose of the sensor and the integrated circuit. Details of the carrier 7 are therefore not shown in Figure 1. Other appropriate contact connections enabling an external electric connection of the electric conductors 3, like bondwire connections, for example, may be provided instead of the solder balls 6.

Through-substrate vias 8 extend through the substrate 1 from the main surface 1' to the opposite back surface 1''. Metallizations 9 forming electric interconnects are arranged at the sidewalls of the through-substrate vias 8 and are preferably insulated from the semiconductor material by a dielectric material 10. One of the metallizations 9 electrically connects one of the electric conductors 3 at the main surface 1' with a capacitor electrode 11 at or above the back surface 1'', and another one of the metallizations 9 electrically connects another one of the electric conductors 3 with a further capacitor electrode 12 at or above the back surface 1''. In the embodiment shown in Figure 1 the metallizations 9 do not fill the through-substrate vias 8.

The metallizations 9 are preferably at least covered with a protecting or passivating layer, which may comprise the dielectric material 10. Instead, the through-substrate vias 8 may be completely filled with the metallizations 9 or with a further material, which may be electrically conductive or insulating.

In the embodiment according to Figure 1 the capacitor electrode 11 and the further capacitor electrode 12 are arranged on the same level at a distance d from the back surface 1'' of the substrate 1 and can be formed by a structured metallization layer. The application of photolithography renders a precise structure of the metallization layer, which may be a layer portion of the metallizations 9 of the through-substrate vias 8 or may be applied separately as a top metal layer, for example. In an alternative example which does not form part of the invention the capacitor electrode 11 and the further capacitor electrode 12 can instead be arranged on different levels, at different distances from the back surface 1'' of the substrate 1, and can be formed in different metallization layers, which can be separated by the dielectric material 10 or another suitable capacitor dielectric.

There may be a plurality of further capacitor electrodes 12, 13, 14, which can be arranged on the same level or in different metallization layers. Individual through-substrate vias 8 may be provided for each of the further capacitor electrodes 12, 13, 14, which can thus be connected separately with different electric conductors 3. A plurality of capacitor electrodes is particularly suitable if an array of individual sensors is to be formed or if a large number of sensor devices is to be produced on the same wafer.

A further electrode 15, which may be used for a capacitive coupling between the capacitor electrode 11 and the further capacitor electrode 12 and will therefore be designated as coupling electrode 15, is arranged in the vicinity of the capacitor electrode 11 and the further capacitor electrode 12. The coupling electrode 15 may have any suitable shape and may comprise any electrically conductive material, especially a metal or doped polysilicon, for example. The coupling electrode 15 is not electrically connected and may be completely surrounded by insulating material. In this case the coupling electrode 15 is electrically floating, which means that no electric voltage is applied to the coupling electrode 15. The coupling electrode 15 is arranged at a larger distance d' from the back surface 1'' than the capacitor electrode 11 and the further capacitor electrode 12, and preferably overlaps the area of at least one of the capacitor electrodes 11, 12 in order to enhance the capacitive coupling and thereby increase the capacitance of the array of capacitor electrodes 11, 12.

The material forming the intermediate capacitor dielectric between the capacitor electrode 11, the further capacitor electrode 12 and/or the coupling electrode 15 may be selected to be a material with a dielectric constant that depends in a special way on the presence and/or concentration of a gas, in particular water vapour. The gas changes the capacitance of the array of electrodes and intermediate capacitor dielectric with respect to its capacitance in a standard environment and can therefore be detected by a capacitive measurement. Fixed electrodes may therefore be particularly suitable for a gas sensor or a humidity sensor. The capacitor dielectric can be formed by a region of the dielectric material 10, or it can be a different dielectric material, which may be confined to the region between the capacitor electrode 11, the further capacitor electrode 12, and/or the coupling electrode 15.

Figure 2 shows a cross section of an embodiment comprising a movable coupling electrode 15, which may be arranged within a void 20 formed in the dielectric material 10, so that the coupling electrode 15 is protected. The elements of the embodiment according to Figure 2 that correspond to elements of the embodiment according to Figure 1 are designated with the same reference numerals. The coupling electrode 15 may be formed from a metal, for example, or from polysilicon, which may be provided with a doping or with a metal film rendering the coupling electrode 15 at least partially electrically conductive. Suspensions 19 may optionally be provided to suspend the movable coupling electrode 15 at desired distances from the capacitor electrode 11, the further capacitor electrode 12 and the surrounding dielectric material 10. The suspensions 19 may be arranged in any appropriate form and may be fastened to the dielectric material 10 or to the back surface 1'' of the substrate 1, for instance. In Figure 2 the suspensions 19 are represented with broken lines indicating that, in this example, the suspensions 19 are located in front of the plane of the drawing and behind the plane of the drawing.

The coupling electrode 15 may have any suitable shape. If it is provided to act as an inertial mass, it can have any shape that is known per se from micromechanical sensors like acceleration sensors or gyroscopes. If the coupling electrode 15 comprises polysilicon, the suspensions 19 may be formed by resilient polysilicon strips. The coupling electrode 15 may also be formed as a cantilever having a supporting section fastened to the dielectric material 10 or to the back surface 1'' of the substrate 1, and a resilient section provided to vibrate in the void 20.

The coupling electrode 15 may be arranged on an external surface of the device, but it is preferably provided with some kind of protection. For this purpose the coupling electrode 15 can be arranged in a void 20 that is closed or surrounded by the dielectric material 10, as shown in Figure 2. An opening or recess in the dielectric material 10 or in any other covering layer that is arranged above the back surface 1'' may instead suffice to accomodate the movable coupling electrode 15 and to provide a sufficient protection.

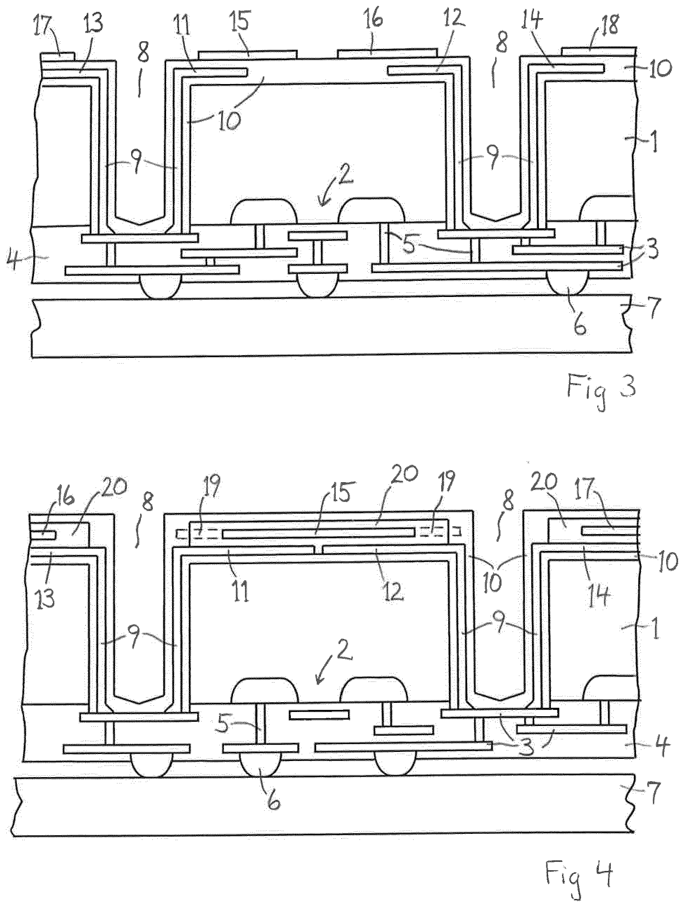

Figure 3 shows a cross section of an embodiment comprising a fixed coupling electrode 15 and further fixed coupling electrodes 16, 17, 18, which are arranged above the back surface 1'' of the substrate 1. The elements of the embodiment according to Figure 3 that correspond to elements of the embodiment according to Figure 1 are designated with the same reference numerals. The further coupling electrodes 16, 17, 18 may be provided for a capacitive coupling between any of the capacitor electrode 11 and the further capacitor electrodes 12, 13, 14 and are therefore preferably arranged in the vicinity of the relevant capacitor electrodes 11, 12, 13, 14. The further coupling electrodes 16, 17, 18 may comprise any electrically conductive material, especially a metal or doped polysilicon, for example. The further coupling electrodes 16, 17, 18 may be electrically floating and may be completely surrounded by insulating material. An electric connection may instead be provided for any of the coupling electrodes 16, 17, 18, in particular by means of further through-substrate vias 8.

Figure 4 shows a cross section of an embodiment comprising a movable coupling electrode 15 and further movable coupling electrodes 16, 17, which are arranged within voids 20 formed in the dielectric material 10. The elements of the embodiment according to Figure 4 that correspond to elements of the embodiment according to Figure 2 are designated with the same reference numerals. The voids 20 may be substituted with openings or recesses in the dielectric material 10 or in any other covering layer arranged above the back surface 1''. The above description of the movable coupling electrode 15 also applies to the further movable coupling electrodes 16, 17, which may each be provided with suspensions and may be formed to act as an inertial mass. It is also possible to provide the semiconductor device with both fixed and movable coupling electrodes, thus facilitating the monolithic integration of an acceleration sensor, a humidity sensor and an integrated circuit, for example. Furthermore it is thus possible to produce a large number of different kinds of sensor devices on the same wafer.

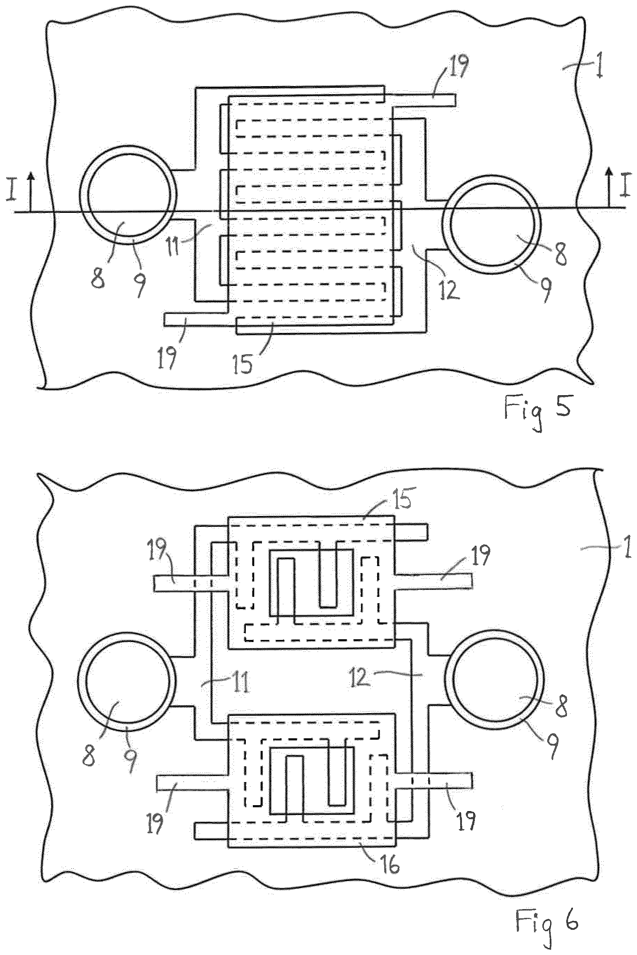

Figure 5 shows a plan view of the embodiments according to Figure 1 or Figure 2 as seen in the direction from above towards the back surface 1'' of the substrate 1, with the capacitor electrodes and coupling electrodes uncovered. The position of the cross section shown in Figures 1 and 2 is indicated in Figure 5 by a horizontal line and arrows showing the direction of viewing. The dielectric material 10 is not shown in Figure 5, which represents the structure of the electrodes as if the dielectric material 10 were transparent. The elements of Figure 5 that correspond to elements of the embodiments according to Figures 1 and 2 are designated with the same reference numerals. The through-substrate vias 8 are shown to be cylindrical, which may be a preferred shape regarding the production process, but they can have any other suitable shape as well. The metallizations 9 are preferably confined to the sidewalls of the through-substrate vias 8. The capacitor electrode 11 and the further capacitor electrode 12 are interdigitated to increase the capacitance. Other patterns of the capacitor electrode 11 and the further capacitor electrode 12 may be appropriate as well, depending on individual requirements of the embodiments. The coupling electrode 15 has a rectangular shape, but it can have any suitable other shape as well. If the coupling electrode 15 is to be movably suspended, suspensions 19 may be provided by lateral extensions of the coupling electrode 15 and may be anchored in the material that laterally encloses the coupling electrode 15. The suspensions 19 may be adapted to the intended mobility of the coupling electrode 15, also depending on the desired directions of maximal sensitivity.

Figure 6 shows a plan view according to Figure 5 for a further embodiment. The elements of Figure 6 that correspond to elements of the embodiment according to Figure 5 are designated with the same reference numerals. In the embodiment according to Figure 6, the capacitor electrode 11 and the further capacitor electrode 12 are interdigitated in another fashion. The coupling electrode 15 and the further coupling electrode 16 are framelike and only partially overlap with the branches of the capacitor electrodes 11, 12. The coupling electrodes 15, 16 can both be movable or both fixed, or the coupling electrode 15 can be fixed and the further coupling electrode 16 movable, for instance. The examples of Figures 5 and 6 show that there is a multitude of structures by which the electrodes can be adapted to the individual requirements of the sensor device.

This invention has the advantage that an integrated circuit with integrated electrodes can be mounted using WLCSP (wafer-level chip-scale package). This avoids an inconvenient step of arranging the capacitive electrodes on the top of the chip, above the active circuit components, and in addition allows bondwire connections to be made. This invention has a major advantage over non-integrated solutions in that parasitic capacitances associated with the electrodes are minimised, very stable, and fixed at time of manufacture. This eliminates many error sources present if the electrodes are mounted on a printed circuit board or any other location remote from the integrated circuit. This invention allows the electrodes to be patterned with a semiconductor photolithography step allowing highly accurate layout, which is of great advantage in the case of position sensors where the lateral position is to be sensed.

### List of reference numerals

- 1: substrate
- 1': main surface
- 1'': back surface
- 2: integrated component
- 3: electric conductor
- 4: intermetal dielectric
- 5: plug
- 6: solder ball
- 7: carrier
- 8: through-substrate via
- 9: metallization
- 10: dielectric material
- 11: capacitor electrode
- 12: further capacitor electrode
- 13: further capacitor electrode
- 14: further capacitor electrode
- 15: coupling electrode
- 16: further coupling electrode
- 17: further coupling electrode
- 18: further coupling electrode
- 19: suspension
- 20: void
- d: distance
- d': distance

## Claims

1. A semiconductor device, comprising:
- a substrate (1) of semiconductor material with a main surface (1') and an opposite back surface (1''),
- at least one integrated component (2) arranged in the substrate (1) at or near the main surface (1'),
- a plurality of electric conductors (3) at or above the main surface (1'), the integrated component (2) being electrically connected with the electric conductors (3),
- a capacitor electrode (11) and at least one further capacitor electrode (12) arranged at or above the back surface (1''), and
- through-substrate vias (8) with metallizations (9), each of the metallizations (9) connecting one of the electric conductors (3) with either the capacitor electrode (11) or the further capacitor electrode (12), wherein
- the capacitor electrode (11) and the further capacitor electrode (12) are arranged at the same level at a distance (d) from the back surface (1'') of the substrate (1), and
- at least one coupling electrode (15) is arranged in the vicinity of the capacitor electrode (11) and the further capacitor electrode (12), **characterized in that**
- the coupling electrode (15) overlaps the capacitor electrode (11),
- the coupling electrode (15) or a further coupling electrode (16) overlaps the further capacitor electrode (12), and
- the coupling electrode (15) is electrically floating.

2. The semiconductor device according to claim 1, wherein the capacitor electrode (11) and the further capacitor electrode (12) are interdigitated.

3. The semiconductor device according to claim 1 or 2, wherein
the coupling electrode (15) is arranged at a distance (d') from the back surface (1''), and
the capacitor electrode (11) and the further capacitor electrode (12) are arranged within this distance (d') from the back surface (1'').

4. The semiconductor device according to one of claims 1 to 3, wherein the coupling electrode (15) is fixed relative to the capacitor electrode (11) and the further capacitor electrode (12).

5. The semiconductor device according to claim 4, further comprising a dielectric material (10) between the capacitor electrode (11), the further capacitor electrode (12), and/or the coupling electrode (15).

6. The semiconductor device according to claim 5, wherein the dielectric material (10) is provided for a gas sensor.

7. The semiconductor device according to claim 5, wherein the dielectric material (10) is provided for a humidity sensor.

8. The semiconductor device according to one of claims 1 to 3, wherein the coupling electrode (15) is movable with respect to the capacitor electrode (11) and the further capacitor electrode (12).

9. The semiconductor device according to claim 8, further comprising:
a dielectric material (10) forming a recess or void (20) at or above the back surface (1''), and
the coupling electrode (15) being suspended within the recess or void (20) by means of suspensions (19) extending to or into the dielectric material (10).

10. The semiconductor device according to one of claims 1 to 9, further comprising:
solder balls (6) arranged on some of the electric conductors (3), thus enabling an external electric connection of the electric conductors (3).

11. The semiconductor device according to one of claims 1 to 10, further comprising:
a plurality of further capacitor electrodes (12, 13, 14) arranged at or above the back surface (1''),
a plurality of further coupling electrodes (16, 17, 18), each of the further coupling electrodes (16, 17, 18) being arranged in the vicinity of one or more of the further capacitor electrodes (12, 13, 14), and
a plurality of through-substrate vias (8) with metallizations (9) providing connections between the electric conductors (3) and the further capacitor electrodes (12, 13, 14) in pairs each formed by one of the electric conductors (3) and one of the further capacitor electrodes (12, 13, 14).

## Patentansprüche

1. Halbleiterbauteil, umfassend:
- ein Substrat (1) aus Halbleitermaterial mit einer Hauptfläche (1') und einer entgegengesetzten hinteren Fläche (1"),
- mindestens ein integriertes Bauteil (2), das im Substrat (1) an oder nahe der Hauptfläche (1') angeordnet ist,
- mehrere elektrische Leiter (3) an oder über der Hauptfläche (1'), wobei das integrierte Bauteil (2) elektrisch mit den elektrischen Leitern (3) verbunden ist,
- eine Kondensatorelektrode (11) und mindestens eine weitere Kondensatorelektrode (12), die an oder über der hinteren Fläche (1") angeordnet sind, und
- Substratdurchkontaktierungen (8) mit Metallisierungen (9), wobei jede der Metallisierungen (9) einen der elektrischen Leiter (3) mit entweder der Kondensatorelektrode (11) oder der weiteren Kondensatorelektrode (12) verbindet,
wobei
- die Kondensatorelektrode (11) und die weitere Kondensatorelektrode (12) auf derselben Höhe in einem Abstand (d) von der hinteren Fläche (1") des Substrats (1) angeordnet sind, und
- mindestens eine Kopplungselektrode (15) in der Nähe der Kondensatorelektrode (11) und der weiteren Kondensatorelektrode (12) angeordnet ist,
**dadurch gekennzeichnet, dass**
- die Kopplungselektrode (15) die Kondensatorelektrode (11) überdeckt,
- die Kopplungselektrode (15) oder eine weitere Kopplungselektrode (16) die weitere Kondensatorelektrode (12) überdeckt, und
- die Kopplungselektrode (15) ungeerdet ist.

2. Halbleiterbauteil nach Anspruch 1, wobei die Kondensatorelektrode (11) und die weitere Kondensatorelektrode (12) ineinandergreifend sind.

3. Halbleiterbauteil nach Anspruch 1 oder 2, wobei die Kopplungselektrode (15) in einem Abstand (d') von der hinteren Fläche (1") angeordnet ist, und die Kondensatorelektrode (11) und die weitere Kondensatorelektrode (12) innerhalb dieses Abstands (d') von der hinteren Fläche (1") angeordnet sind.

4. Halbleiterbauteil nach einem der Ansprüche 1 bis 3, wobei die Kopplungselektrode (15) in Bezug auf die Kondensatorelektrode (11) und die weitere Kondensatorelektrode (12) feststehend ist.

5. Halbleiterbauteil nach Anspruch 4, darüber hinaus ein dielektrisches Material (10) zwischen der Kondensatorelektrode (11), der weiteren Kondensatorelektrode (12) und/oder der Kopplungselektrode (15) umfassend.

6. Halbleiterbauteil nach Anspruch 5, wobei das dielektrische Material (10) für einen Gassensor vorgesehen ist.

7. Halbleiterbauteil nach Anspruch 5, wobei das dielektrische Material (10) für einen Feuchtigkeitssensor vorgesehen ist.

8. Halbleiterbauteil nach einem der Ansprüche 1 bis 3, wobei die Kopplungselektrode (15) in Bezug auf die Kondensatorelektrode (11) und die weitere Kondensatorelektrode (12) beweglich ist.

9. Halbleiterbauteil nach Anspruch 8, darüber hinaus umfassend:
ein dielektrisches Material (10), das eine Ausnehmung oder einen Hohlraum (20) an oder über der hinteren Fläche (1") bildet, und
wobei die Kopplungselektrode (15) mittels Aufhängungen (19), die sich zu dem dielektrischen Material (10) oder in das dielektrische Material (10) erstrecken, in der Ausnehmung oder dem Hohlraum (20) aufgehängt ist.

10. Halbleiterbauteil nach einem der Ansprüche 1 bis 9, darüber hinaus umfassend:
Lotkugeln (6), die auf einigen der elektrischen Leiter (3) angeordnet sind, womit eine externe elektrische Verbindung der elektrischen Leiter (3) ermöglicht wird.

11. Halbleiterbauteil nach einem der Ansprüche 1 bis 10, darüber hinaus umfassend:
mehrere weitere Kondensatorelektroden (12, 13, 14), die an oder über der hinteren Fläche (1") angeordnet sind,
mehrere weitere Kopplungselektroden (16, 17, 18),
wobei jede der weiteren Kopplungselektroden (16, 17, 18) in der Nähe einer oder mehrerer der weiteren Kondensatorelektroden (12, 13, 14) angeordnet ist, und
mehrere Substratdurchkontaktierungen (8) mit Metallisierungen (9), die Verbindungen zwischen den elektrischen Leitern (3) und den weiteren Kondensatorelektroden (12, 13, 14) in Paaren bereitstellen, die jeweils durch einen der elektrischen Leiter (3) und eine der weiteren Kondensatorelektroden (12, 13, 14) gebildet sind.

## Revendications

1. Dispositif semiconducteur, comprenant :
- un substrat (1) de matériau semiconducteur avec une surface principale (1') et une surface arrière (1") opposée,
- au moins un composant intégré (2) agencé dans le substrat (1) sur ou près de la surface principale (1'),
- une pluralité de conducteurs électriques (3) sur ou au-dessus de la surface principale (1'), le composant intégré (2) étant électriquement connecté aux conducteurs électriques (3),
- une électrode de condensateur (11) et au moins une électrode de condensateur supplémentaire (12) agencées sur ou au-dessus de la surface arrière (1"), et
- des interconnexions verticales de substrat (8) avec des métallisations (9), chacune des métallisations (9) connectant un des conducteurs électriques (3) soit à l'électrode de condensateur (11) soit à l'électrode de condensateur supplémentaire (12),
sachant que
- l'électrode de condensateur (11) et l'électrode de condensateur supplémentaire (12) sont agencées au même niveau à une distance (d) par rapport à la surface arrière (1"") du substrat (1), et
- au moins une électrode de couplage (15) est agencée à proximité de l'électrode de condensateur (11) et de l'électrode de condensateur supplémentaire (12), **caractérisée en ce que**
- l'électrode de couplage (15) chevauche l'électrode de condensateur (11),
- l'électrode de couplage (15) ou une électrode de couplage supplémentaire (16) chevauche l'électrode de condensateur supplémentaire (12), et
- l'électrode de couplage (15) n'est pas mise à la terre.

2. Le dispositif semiconducteur selon la revendication 1, sachant que l'électrode de condensateur (11) et l'électrode de condensateur supplémentaire (12) sont interdigitées.

3. Le dispositif semiconducteur selon la revendication 1 ou 2, sachant que
l'électrode de couplage (15) est agencée à une distance (d') par rapport à la surface arrière (1"), et
l'électrode de condensateur (11) et l'électrode de condensateur supplémentaire (12) sont agencées à l'intérieur de cette distance (d') par rapport à la surface arrière (1").

4. Le dispositif semiconducteur selon l'une des revendications 1 à 3, sachant que l'électrode de couplage (15) est fixe par rapport à l'électrode de condensateur (11) et l'électrode de condensateur supplémentaire (12).

5. Le dispositif semiconducteur selon la revendication 4, comprenant en outre un matériau diélectrique (10) entre l'électrode de condensateur (11), l'électrode de condensateur supplémentaire (12), et/ou l'électrode de couplage (15).

6. Le dispositif semiconducteur selon la revendication 5, sachant que le matériau diélectrique (10) est prévu pour un détecteur de gaz.

7. Le dispositif semiconducteur selon la revendication 5, sachant que le matériau diélectrique (10) est prévu pour un détecteur d'humidité.

8. Le dispositif semiconducteur selon l'une des revendications 1 à 3, sachant que l'électrode de couplage (15) est mobile par rapport à l'électrode de condensateur (11) et à l'électrode de condensateur supplémentaire (12).

9. Le dispositif semiconducteur selon la revendication 8, comprenant en outre :
un matériau diélectrique (10) formant une cavité ou un vide (20) sur ou au-dessus de la surface arrière (1"), et
l'électrode de couplage (15) étant suspendue à l'intérieur de la cavité ou du vide (20) au moyen de suspensions (19) s'étendant vers ou dans le matériau diélectrique (10).

10. Le dispositif semiconducteur selon l'une des revendications 1 à 9, comprenant en outre :
des billes de soudure (6) agencées sur quelques-uns des conducteurs électriques (3), permettant de la sorte une connexion électrique externe des conducteurs électriques (3).

11. Le dispositif semiconducteur selon l'une des revendications 1 à 10, comprenant en outre :
une pluralité d'électrodes de condensateur supplémentaires (12, 13, 14) agencées sur ou au-dessus de la surface arrière (1"),
une pluralité d'électrodes de couplage supplémentaires (16, 17, 18), chacune des électrodes de couplage supplémentaires (16, 17, 18) étant agencée à proximité d'une ou de plusieurs des électrodes de condensateur supplémentaires (12, 13, 14), et
une pluralité d'interconnexions verticales de substrat (8) avec des métallisations (9) fournissant des connexions entre les conducteurs électriques (3) et les électrodes de condensateur supplémentaires (12, 13, 14) par paires formées chacune par un des conducteurs électriques (3) et une des électrodes de condensateur supplémentaires (12, 13, 14).
